(19) Europäisches Patentamt / European Patent Office / Office européen des brevets

(11) **EP 3 443 678 B1**

(12) **FASCICULE DE BREVET EUROPEEN**

(45) Date de publication et mention de la délivrance du brevet:
**22.01.2020 Bulletin 2020/04**

(21) Numéro de dépôt: **17720025.0**

(22) Date de dépôt: **12.04.2017**

(51) Int Cl.:
***H03M 13/13*** *(2006.01)*

(86) Numéro de dépôt international:
**PCT/EP2017/058882**

(87) Numéro de publication internationale:
**WO 2017/178567 (19.10.2017 Gazette 2017/42)**

(54) **METHODE DE DÉCODAGE D'UN CODE POLAIRE AVEC INVERSION DE BITS PEU FIABLES**

VERFAHREN ZUR DEKODIERUNG EINES POLARCODES MIT UMKEHRUNG VON BITS MIT NIEDRIGER ZUVERLÄSSIGKEIT

METHOD OF DECODING A POLAR CODE WITH INVERSION OF LOW RELIABILITY BITS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.04.2016 FR 1653339**

(43) Date de publication de la demande:
**20.02.2019 Bulletin 2019/08**

(73) Titulaires:
- **Commissariat à l'Energie Atomique et aux Energies Alternatives**
  **75015 Paris (FR)**
- **Université de Cergy-Pontoise**
  **95011 Cergy-Pontoise Cedex (FR)**
- **ENSEA - Ecole Nationale Supérieure de L'Electronique et de ses Applications**
  **95014 Cergy-Pontoise Cedex (FR)**

(72) Inventeurs:
- **CHANDESRIS, Ludovic**
  **38000 GRENOBLE (FR)**
- **DECLERCQ, David**
  **95450 ABLEIGES (FR)**
- **SAVIN, Valentin**
  **38000 GRENOBLE (FR)**

(74) Mandataire: **Brevalex**
  **56, Boulevard de l'Embouchure**
  **B.P. 27519**
  **31075 Toulouse Cedex 2 (FR)**

(56) Documents cités:
- **AFISIADIS ORION ET AL: "A low-complexity improved successive cancellation decoder for polar codes", 2014 48TH ASILOMAR CONFERENCE ON SIGNALS, SYSTEMS AND COMPUTERS, IEEE, 2 novembre 2014 (2014-11-02), pages 2116-2120, XP032769252, DOI: 10.1109/ACSSC.2014.7094848**
- **ZHANG ZHAOYANG ET AL: "A Split-Reduced Successive Cancellation List Decoder for Polar Codes", IEEE JOURNAL ON SELECTED AREAS IN COMMUNICATIONS, IEEE SERVICE CENTER, PISCATAWAY, US, vol. 34, no. 2, février 2016 (2016-02), pages 292-302, XP011593861, ISSN: 0733-8716, DOI: 10.1109/JSAC.2015.2504321 [extrait le 2016-01-15]**

**Description**

**DOMAINE TECHNIQUE**

La présente invention concerne de manière générale le domaine des codes correcteurs d'erreurs et plus particulièrement celui des codes polaires.

**ÉTAT DE LA TECHNIQUE ANTÉRIEURE**

Les codes polaires sont une famille de codes correcteurs d'erreurs qui possède la propriété remarquable de pouvoir atteindre asymptotiquement, c'est-à-dire lorsque la longueur du code devient infinie, la capacité de Shannon de n'importe quel canal binaire symétrique sans mémoire.

Les codes polaires ont été introduits et décrits dans l'article de E. Arikan intitulé « Channel polarization : a method for constructing capacity-achieving codes for symmetric binary-input memoryless channels » publié dans IEEE Trans on Infomation Theory, Vol. 55, No. 7, pp. 3051-3073. Les principales caractéristiques des codes polaires sont rappelées ci-après.

Nous décrirons ci-après les codes polaires sur un canal binaire symétrique sans mémoire dit MBS (Memoryless Binary Channel) noté $W$. Ce canal est caractérisé par son alphabet d'entrée $X = \{0,1\}$, son alphabet de sortie $Y$ et ses probabilités de transition $W(y|x)$. Le canal vectoriel constitué par $N$ utilisations successives du canal $W$ est noté $W^N$, permet par conséquent de transmettre des mots de $N$ bits. Le canal vectoriel $W^N : X^N \to Y^N$ est caractérisé par son alphabet d'entrée $X^N$, son alphabet de sortie $Y^N$ et ses probabilités de transition, qui ne sont autres que

$$W^N\left(y^N\middle|x^N\right) = \prod_{i=1}^{N} W\left(y_i\middle|x_i\right)$$ où $y^N = (y_1,...,y_N) \in Y^N$ et $x^N = (x_1,...,x_N) \in X^N$. On supposera dans la suite que $N = 2^n$.

On synthétise de manière récursive, à partir du canal élémentaire $W$, un canal virtuel $W_N : X^N \to Y^N$, autrement dit le canal virtuel d'ordre 1 n'est autre que le canal réel $W : W_1 = W$. Le canal virtuel d'ordre 2, $W_2 : X^2 \to Y^2$ obtenu après une première itération est donné par :

$$W_2\left(y_1, y_2\middle|u_1, u_2\right) = W\left(y_1\middle|u_1 \oplus u_2\right) W\left(y_2\middle|u_2\right) \tag{1}$$

qui peut encore s'écrire de manière équivalente à partir du canal vectoriel $W^2$ :

$$W_2\left(y_1^2\middle|u_1^2\right) = W^2\left(y_1^2\middle|u_1^2 G_2\right) \tag{2}$$

avec

$$y_1^2 = \left(y_1, y_2\right) \in \mathcal{Y}^2,$$

$u_1^2 = \left(u_1, u_2\right) \in \mathcal{X}^2$, et :

$$G_2 = F = \begin{pmatrix} 1 & 0 \\ 1 & 1 \end{pmatrix} \tag{3}$$

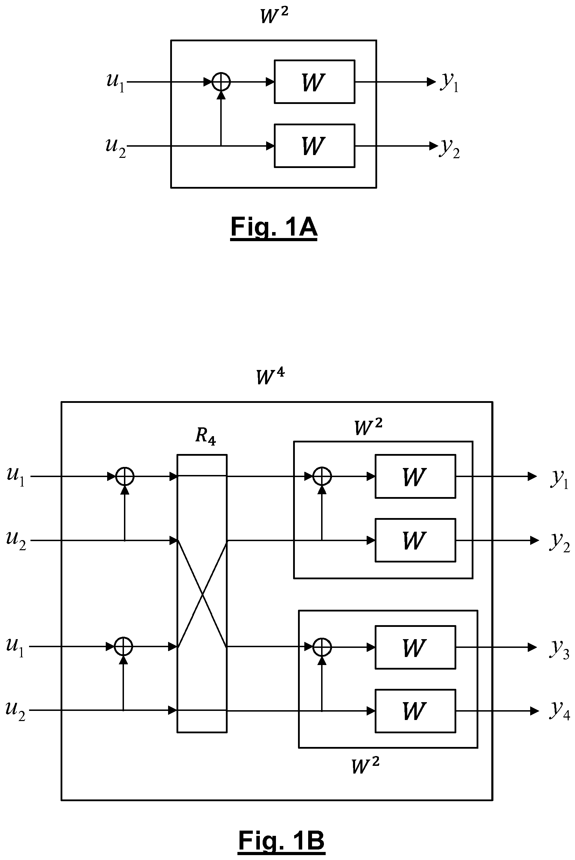

On a représenté schématiquement en Fig. 1A, le canal virtuel d'ordre 2, obtenu à partir du canal réel. De manière similaire, le canal virtuel d'ordre 4 peut être obtenu après une seconde itération comme indiqué en Fig. 1B, moyennant une étape de permutation $R_4$.

De manière générale, on construit le canal virtuel d'ordre $N$, $W_N : X^N \to Y^N$ à partir du canal vectoriel $W^N$ :

$$W_N\left(y_1^N\middle|u_1^N\right) = W^2\left(y_1^N\middle|u_1^N G_N\right) \tag{4}$$

avec

$$y_1^N = (y_1, .., y_N) \in \mathcal{Y}^N,$$

$u_1^N = (u_1, ..., u_N) \in \mathcal{X}^N$, et $G_N = B_N F^{\otimes n}$ où $B_N$ est une matrice de permutation dite de retournement binaire (*bit reversal*) et $F^{\otimes n}$ est la $n^{\text{ème}}$ puissance de Kronecker de la matrice $F$.

La construction d'un code polaire est basée sur une sélection de $K$ parmi les $2^n$ sous-canaux virtuels binaires

$$W_N^{(i)} : \mathcal{X} \to \mathcal{Y}^N \times \mathcal{X}^{i-1},$$

$i = 1, .., N$ définis par :

$$W_N^{(i)}\left(y_1^N, u_1^{i-1} \middle| u_i\right) = \sum_{u_{i+1}^N \in \mathcal{X}^{N-i}} \frac{1}{2^{N-1}} W_N\left(y_1^N \middle| u_1^N\right) \tag{5}$$

l'entrée du canal étant donnée par $u_i \in X$ et la sortie par

$$\left(y_1^N, u_1^{i-1}\right) \in \mathcal{Y}^N \times \mathcal{X}^{i-1}.$$

Autrement dit, le sous-canal virtuel binaire $W_N^{(i)}$ est un canal pour lequel on estime le bit $u_i$ à partir du vecteur observé $y_1^N$ à la sortie du canal $W_N$ ainsi que d'une information auxiliaire constituée des $i - 1$ estimations $(\hat{u}_1, ..., \hat{u}_{i-1})$ précédentes supposées correctes.

L'intérêt des codes polaires découle d'un phénomène dit de polarisation. Plus précisément, lorsque la taille $N$ du code croît, certains des sous-canaux virtuels binaires précités voient leur capacité tendre vers 1 alors que certains autres voient leur capacité tendre vers 0. La construction d'un code polaire de rendement $R = K / N$ consiste à choisir $K$ sous-canaux virtuels binaires parmi ceux dont la capacité est la plus élevée (autrement dit ceux qui sont polarisés vers 1). Les $K$ sous-canaux sélectionnés transmettent les $K$ bits d'information et les bits à l'entrée des $N - K$ sous-canaux restants sont figés à des valeurs prédéterminées connues de l'émetteur et du récepteur. Pour des raisons de simplification, les bits à l'entrée de ces $N - K$ sous-canaux sont pris conventionnellement égaux à zéro.

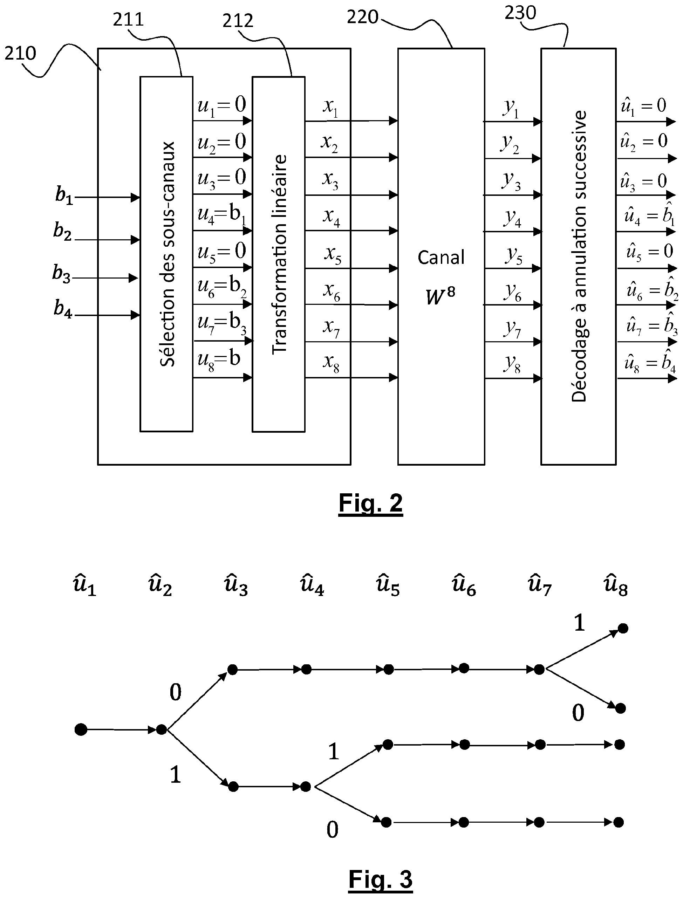

La Fig. 2 représente de manière schématique un exemple d'un système de codage et de décodage pour un code polaire de taille $N = 8$, $K = 4$ et donc de rendement 1/2.

Le codeur polaire 210 reçoit les $K$ bits à transmettre sur le canal $W$. Le module 211 effectue une sélection des $K$ sous-canaux virtuels binaires présentant la plus forte capacité pour transmettre les $K$ bits d'information, $b_1, b_2, b_3, b_4$. Les $N - K$ bits restants sont fixés à zéro. Le vecteur résultant, $u_1^8$, subit une transformation linéaire $x_1^8 = u_1^8 G_8$ dans le module 213, où $G_8$ est donnée par l'expression (5).

Le mot de 8 bits en sortie du module de combinaison linéaire est ensuite transmis sur le canal vectoriel $W^8$, 220, autrement dit les bits $x_1, ..., x_8$ sont successivement transmis sur le canal $W$.

Le décodeur 230 reçoit les valeurs bruitées des bits émis, notées $y_1, ..., y_8$ et les exprime en rapports logarithmiques de vraisemblance ou LLRs.

Différents algorithmes de décodage ont été proposés dans la littérature. Toutefois, le décodage dit à annulation successive ou SC (Successive Cancellation) reste à ce jour l'algorithme fondamental pour décoder les codes polaires dans la mesure où tous les algorithmes de décodage les plus performants conservent la structure et le caractère séquentiel de ce type de décodage.

On pourra trouver une description du décodage SC des codes polaires dans l'article d'E. Arikan précité. Le principe du décodage SC est rappelé ci-après. On estime d'abord le premier bit $u_1$ à partir du vecteur des valeurs reçues, $y_1^N = (y_1, ..., y_N)$, soit $\hat{u}_1$ le premier bit estimé. Le second bit $u_2$ est ensuite estimé à partir de $y_1^N$ et $\hat{u}_1$, soit $\hat{u}_2$ le

second bit estimé. Le processus se répète en estimant le troisième bit $u_3$ à partir de $y_1^N$, $\hat{u}_1$, $\hat{u}_2$ et ainsi de suite. Etant donné que $N$ - $K$ bits sont figés et connus du décodeur, seuls les $K$ bits d'information sont en fait à estimer. On définit alors les rapports logarithmiques de vraisemblance de $W_N^{(i)}\left(y_1^N,\hat{u}_1^{i-1}\Big|u_i\right)$ par :

$$L_N^{(i)}\left(y_1^N,\hat{u}_1^{i-1}\Big|u_i\right)=\log\frac{W_N^{(i)}\left(y_1^N,\hat{u}_1^{i-1}\Big|u_i=0\right)}{W_N^{(i)}\left(y_1^N,\hat{u}_1^{i-1}\Big|u_i=1\right)} \tag{6}$$

La valeur de LLR $L_N^{(i)}\left(y_1^N,\hat{u}_1^{i-1}\Big|u_i\right)$ exprime la fiabilité de l'estimation de la valeur du bit $u_i$, compte-tenu du vecteur des valeurs reçues $y_1^N$ et celui des bits précédemment décodés, c'est-à-dire des décisions dures prises sur les bits précédents $\hat{u}_1^{i-1}=\left(\hat{u}_1,...,\hat{u}_{i-1}\right)$. La décision dure prise sur le bit courant est donnée par :

$$\hat{u}_i=0\ \ \text{si}\ \ \ L_N^{(i)}\left(y_1^N,\hat{u}_1^{i-1}\Big|u_i\right)\geq 0\ \text{et}\ i\in A \tag{7-1}$$

$$\hat{u}_i=1\ \ \text{si}\ \ \ L_N^{(i)}\left(y_1^N,\hat{u}_1^{i-1}\Big|u_i\right)< 0\ \text{et}\ i\in A \tag{7-2}$$

$$\hat{u}_i=u_i\ \ \text{si}\ \ \ i\in A_c \tag{7-3}$$

où $A_c$ est l'ensemble des indices des $N$ - $K$ bits figés et $A$ l'ensemble des indices des $K$ bits d'information. En pratique, le calcul des valeurs de LLRs peut être réalisé par propagation au sein d'un graphe comprenant des nœuds de contraintes et des nœuds de variables pour chaque étape $i$ de décodage. On estime ainsi de proche en proche les bits $u_1,...,u_N$.

Le point faible du décodage par annulation successive est inhérent à son caractère séquentiel. En effet, si une décision sur un bit est erronée, l'erreur peut se propager au décodage des bits suivants. Le décodeur SC conventionnel ne revient pas en arrière sur une décision erronée.

Différentes approches ont été proposées pour remédier à la propagation d'erreurs dans le décodage SC.

Une première approche consiste à utiliser un décodage par liste, c'est-à-dire à conserver à chaque étape de décodage une pluralité de chemins (jusqu'à un nombre maximal $L$) les plus probables dans l'arborescence de décodage au lieu de n'en conserver qu'un seul dans le décodage SC. La sélection du meilleur chemin au terme du processus de décodage donne une estimation du mot transmis le plus probable.

On trouvera une description d'un décodage successif par liste de codes polaires dans l'article de I. Tal et al. intitulé « List decoding of polar codes », Information Theory Proc. (ISIT), Juillet 2011, pp. 1-5.

La Fig. 3 représente de manière schématique un exemple de décodage successif par liste d'un code polaire.

On a représenté sur la première ligne les décisions à prendre successivement sur les bits, $\hat{u}_1,...,\hat{u}_8$ dans l'ordre du décodeur à annulation successive. Lorsqu'une décision sur un bit est considérée comme insuffisamment fiable, les deux chemins correspondant aux deux valeurs possibles du bit sont conservés et le décodage se poursuit en parallèle pour les deux chemins. A la fin du décodage, on a non plus un seul mot candidat mais une pluralité (au maximum $L$) de mots candidats, où $L$ est un paramètre fixé à l'avance. La sélection du meilleur candidat dans la liste est effectuée au moyen d'une métrique ou bien d'une vérification au moyen d'un code de détection d'erreur de type CRC.

Les performances du décodeur SC par liste (SCL) sont sensiblement meilleures que celles du décodeur SC et se rapprochent de celles du décodeur au maximum de vraisemblance (ML), lorsque la taille de la liste ($L$) est suffisamment élevée et que la sélection du meilleur candidat dans la liste s'effectue au moyen d'un code de détection d'erreur de type CRC. Cependant, le décodeur SCL est relativement complexe (complexité $L$ fois supérieure à celle du décodeur SC) et exigeant en termes de ressources (calcul et mémoire).

Une seconde approche permet d'obtenir un compromis en termes de complexité et performances entre le décodeur SC et le décodeur SCL. Selon cette approche, au lieu de conserver plusieurs chemins comme dans le décodeur SCL, on autorise un retour en arrière sur le chemin du décodeur SC lorsqu'une erreur est détectée au terme du décodage. Pour ce faire, un code CRC (Cyclic Redundancy Check) est ajouté au niveau du codeur polaire. Au terme du décodage, si le CRC n'est pas vérifié et que le mot décodé est donc erroné, la décision la moins fiable prise sur le chemin de décodage par annulation successive est inversée et les valeurs des bits subséquents sont alors à nouveau estimées en tenant compte de l'inversion effectuée. Si, à l'issue de ce nouveau décodage, le CRC n'est toujours pas vérifié, on choisit la deuxième décision la moins fiable et on réitère le processus.

Le décodage se termine soit lorsque le CRC est vérifié soit lorsque l'on atteint un nombre maximal prédéterminé d'inversions, $M_{max}$, paramètre du décodeur.

On trouvera une description du décodage par inversion dans l'article de O. Afisiadis et al. intitulé « A low-complexity improved successive cancellation decoder for polar codes » publié dans Signals, Systems and Computers, 2014, 48th Asilomar Conference, pp. 2116-2120. Cet article forme la base pour le préambule de la revendication 1.

Il est également à noter que l'article de Z. Zhang et al intitulé "A Split-Reduced Successive Cancellation List Decoder for Polar Codes", publié dans IEEE Journal on Selected Areas in Communications, vol. 34, no. 2, février 2016, pp 292-303, divulgue un décodage SCL de codes polaires avec division de chemin uniquement pour les bits dont le LLR est peu fiable.

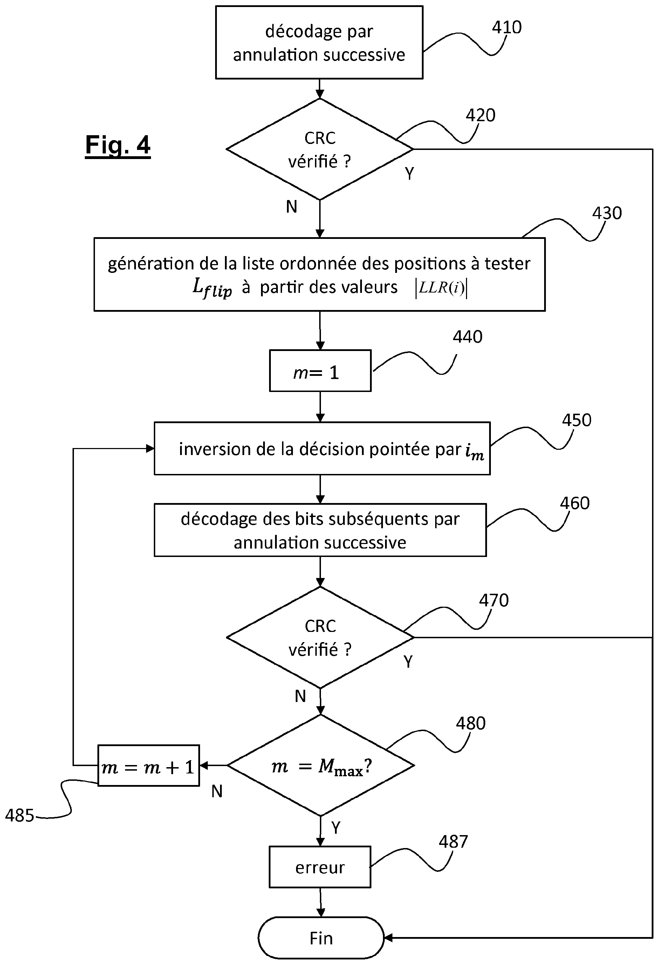

La méthode de décodage par inversion a été représentée schématiquement en Fig. 4.

Lors d'une première étape, 410, on effectue un décodage par annulation successive conventionnel (décodage SC).

A la fin de ce décodage, on teste en 420 si le CRC est vérifié. Dans l'affirmative, le mot décodé est supposé correct et le processus s'arrête en 490. Dans la négative, le mot décodé est nécessairement erroné et l'on passe à l'étape 430.

A l'étape 430, on génère une liste ordonnée, $L_{flip}$, des indices des bits candidats à l'inversion. Cette liste, de longueur maximale $M_{max}$, contient les indices pour lesquels les rapports logarithmiques de vraisemblance (LLR) sont les plus faibles en valeur absolue. Les indices sont rangés par ordre croissant de valeur absolue de valeur de LLR.

A l'étape 440, on initialise un pointeur au premier élément de la liste $L_{flip} = \{i_1,...,i_{M_{max}}\}$, c'est-à-dire $m = 1$.

A l'étape 450, on inverse la décision pointée par la position courante du pointeur $_m$ dans la liste, autrement dit on bascule la valeur du bit correspondant, $\hat{u}_{i_m}$ et l'on procède en 460 à un nouveau décodage des bits subséquents par un décodage SC, en prenant en compte cette nouvelle valeur.

A l'étape 470, on teste à nouveau si le CRC est vérifié. Si c'est le cas, le mot décodé est supposé correct et l'on termine le processus en 490. Dans le cas inverse, on teste en 480 si la valeur du pointeur est égale à $m = M_{max}$.

Dans la négative, on incrémente la valeur du pointeur en 485 et l'on retourne à l'étape 450. En tout état de cause, il convient de noter que l'on n'effectue qu'une seule inversion en cas de CRC erroné. Autrement dit, le bit inversé est rétabli à sa valeur initiale si le CRC n'est pas vérifié.

Dans l'affirmative, c'est-à-dire si on a atteint le nombre maximal d'inversions à tester, on déclare le décodage erroné en 487 et on termine le processus en 490.

Les performances du décodeur par inversion sont dépendantes du choix du nombre maximal d'inversions à tester, $M_{max}$, et de la taille du CRC. Les simulations montrent qu'il est nécessaire de choisir une valeur $M_{max}$ très élevée pour atteindre la borne théorique d'erreur trame, FER (*Frame Error Rate*) ou bit, BER (*Bit Error Rate*) d'un tel décodeur. En contrepartie, cela augmente considérablement le nombre moyen d'inversions effectuées et donc la complexité du décodage, ainsi que la probabilité de collision du CRC, c'est-à-dire la probabilité qu'un décodage erroné vérifie le contrôle CRC et soit par conséquent déclaré comme correct.

Le but de la présente invention est par conséquent de proposer une méthode de décodage de codes polaires par annulation successive qui permette d'atteindre des taux d'erreur sensiblement plus faibles que dans l'état de la technique pour un degré de complexité bien moindre.

## EXPOSÉ DE L'INVENTION

La présente invention est définie par une méthode de décodage d'un code polaire telle que donnée par la revendication 1. Des modes avantageux de réalisation sont définis par les revendications dépendantes.

## BRÈVE DESCRIPTION DES DESSINS

D'autres caractéristiques et avantages de l'invention apparaîtront à la lecture de modes de réalisation préférentiels de l'invention faite en référence aux figures jointes parmi lesquelles :

La Fig. 1A représente de manière schématique un canal virtuel d'ordre 2 obtenu par combinaison de canaux réels;
La Fig. 1B représente de manière schématique un canal virtuel d'ordre 4 obtenu par combinaison de canaux réels;
La Fig. 2 représente de manière schématique un exemple d'un système de codage et de décodage de code polaire connu de l'état de la technique ;
La Fig. 3 représente de manière schématique un exemple de décodage successif par liste d'un code polaire, connu de l'état de la technique ;
La Fig. 4 représente de manière schématique un ordinogramme d'une méthode de décodage par inversion d'un code polaire connue de l'état de l'état de la technique ;

La Fig. 5 représente de manière schématique un ordinogramme d'une méthode de décodage de code polaire selon un premier mode de réalisation de l'invention ;

La Fig. 6 représente le nombre moyen d'inversions en fonction d'un facteur de pondération de la méthode de décodage selon un premier mode de réalisation de l'invention ;

La Fig. 7 représente l'écart par rapport à un décodage par inversion parfait pour la méthode de décodage selon le premier mode de réalisation de l'invention et une méthode de décodage de l'état de la technique ;

Les Figs. 8A et 8B représentent un ordinogramme de la première et de la seconde passes d'une méthode de décodage d'un code polaire selon un second mode de réalisation de l'invention ;

La Fig. 9 représente un taux d'erreur trame (FER) en fonction du rapport signal sur bruit (SNR) pour des méthodes de décodage selon les premier et second modes de réalisation de l'invention ainsi que pour des méthodes de décodage connues de l'état de la technique.

La Fig. 10 représente un taux d'erreur trame en fonction du rapport signal sur bruit pour la méthode de décodage selon le second mode de réalisation en comparaison avec une méthode de décodage SCL connue de l'état de la technique.

## EXPOSÉ DÉTAILLÉ DE MODES DE RÉALISATION PARTICULIERS

La présente invention est basée sur une méthode de décodage par inversion dans laquelle le choix de la position à inverser ne se fait pas selon un critère exprimant le fait que le bit en question soit le moins fiable de la trame reçue, comme dans l'état de la technique, mais selon un critère prenant en compte la probabilité que ce bit soit le premier bit erroné de cette trame. En effet, si une décision erronée est prise sur un bit lors du décodage à annulation successive, alors que ce bit n'était pas nécessairement le moins fiable de la trame (autrement dit possédant la plus faible valeur de LLR en valeur absolue), les décisions prises sur les bits suivants seront très vraisemblablement erronées. Ainsi, lorsqu'une trame est détectée comme erronée, par exemple au moyen d'un CRC, il importe davantage de déterminer le premier bit erroné de la trame que celui présentant le plus faible degré de fiabilité. La présente invention propose d'obtenir une liste ordonnée des positions à inverser à partir d'une nouvelle métrique. Pour une position donnée dans la trame, la métrique prend en compte non seulement la fiabilité de la décision sur le bit à la position en question mais aussi la fiabilité des décisions prises sur au moins une partie des bits qui le précèdent dans la trame.

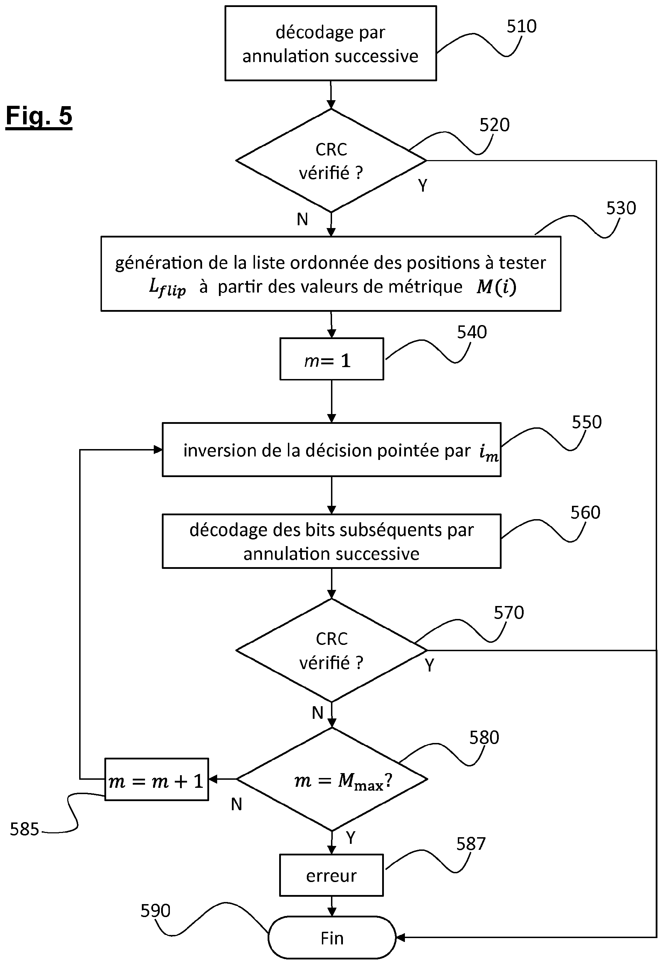

Plus précisément, la Fig. 5 représente de manière schématique l'ordinogramme d'une méthode de décodage de code polaire selon un premier mode de réalisation de l'invention.

A l'exception de l'étape 530, les étapes 510 à 590 sont identiques aux étapes 410 à 490 et leur description ne sera donc pas répétée ici.

L'étape 530 génère comme l'étape 430 une liste ordonnée, $L_{flip}$, des positions à inverser en cas de non vérification de CRC. Cette liste est toutefois construite à partir d'une nouvelle métrique, dénommée dans la suite métrique de première erreur. Cette métrique prend en compte non seulement la fiabilité du bit décodé mais aussi la fiabilité de l'ensemble des bits décodés précédemment, voire d'un sous-ensemble de ceux-ci seulement. La métrique de première erreur peut s'écrire de manière générale sous la forme :

$$M(k) = F\left(\left|LLR(k)\right|; \left|LLR(1)\right|, ..., \left|LLR(k-1)\right|\right) \qquad (8)$$

où F est une fonction monotone des valeurs absolues $|LLR(1)|, ..,|LLR(k)|$ ou de certaines d'entre elles seulement.

Selon une première variante, la métrique de première erreur s'exprime sous la forme :

$$M(k) = \left|LLR(k)\right| + \alpha.S.Card\left\{i \in \left[1,..,k-1\right], \left|LLR(i)\right| < S\right\} \qquad (9)$$

où $S > 0$ est un seuil en deçà duquel la décision sur un bit est considérée comme non fiable et $0 < \alpha \leq 1$ est un facteur de pondération. Le premier terme de la métrique donne le degré de fiabilité du bit $k$, le second terme donne le nombre de bits précédant le bit $k$ considérés comme suspects, autrement dit dont le degré de fiabilité est considéré comme insuffisant. A noter que les valeurs absolues de LLR peuvent être remplacées de manière plus générale par des mesures de fiabilité des bits décodés, sans pour autant sortir du cadre de la présente invention.

Lorsque la métrique (9) est adoptée, la liste ordonnée $L_{flip}$ est obtenue à l'étape 530, comme indiqué ci-après.

Dans un premier temps, on génère une liste, $L_S$, contenant les indices de tous les bits (de manière équivalente la liste de toutes les positions) de la trame pour lesquels la valeur de LLR est inférieure au seuil $S$ en valeur absolue, à savoir :

$$L_S = \left\{ j \in [1,..,N], \left| LLR(j) \right| < S \right\} = \left\{ j_1,...,j_M, 1 \leq j_1 < j_2 < ... < j_M \leq N \right\}$$

$$(10)$$

où $M$ est le nombre de bits considérés comme non fiables.

Dans un second temps, on pénalise chacun des bits de la liste par le nombre de bits suspects le précédant. Plus précisément, le premier bit décodé de la liste $L_S$, d'indice $j_1$, se voit attribuer la valeur de métrique $|LLR(j_1)|$, le second, d'indice $j_2$, se voit attribuer la valeur de métrique $|LLR(j_2)| + \alpha S$ et ainsi de suite. Ainsi, de manière générale le $m^{\text{ième}}$ bit de la liste se voit attribuer la valeur de métrique :

$$M \left( j_m \right) = \left| LLR \left( j_m \right) \right| + \left( m - 1 \right) \alpha S$$

$$(11)$$

La liste $L_{flip}$ est obtenue à partir de la liste $L_S$ en ordonnant les indices $j_1, ..., j_M$ selon les valeurs de métrique croissantes et en ne sélectionnant que les $M_{max}$ premiers indices ainsi ordonnés, soit $L_{flip} = \{i_1, ..., i_{Mmax}\}$

Le facteur de pondération $\alpha$ exprime le poids relatif attribué à la fiabilité du bit et à son rang dans la liste des bits peu fiables. Le facteur de pondération $\alpha$ peut être optimisé par simulation.

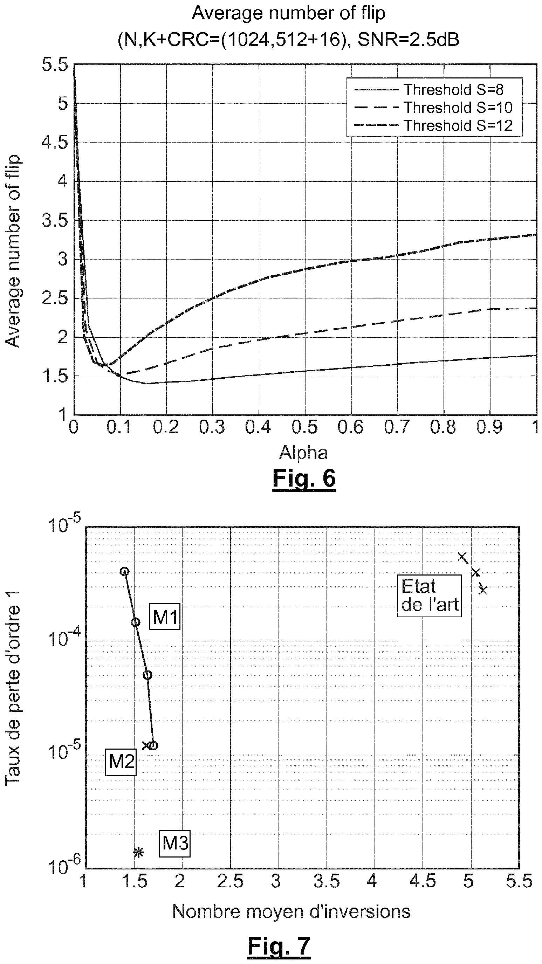

La Fig. 6 représente le nombre moyen d'inversions en fonction du facteur de pondération $\alpha$ pour différentes valeurs de seuil $S$. Le code polaire est choisi de taille $N = 1024$, le nombre de bits d'information est $K = 512$ (rendement de code de 1/2), la taille du CRC est de 16.

Le nombre d'inversions réalisées pour obtenir un décodage correct décroît pour de faibles valeurs de $\alpha$ et croît ensuite lentement. On observe empiriquement que le facteur de pondération optimal, correspondant au plus faible nombre d'itérations, est donné par :

$$\alpha_{opt} \approx 1/S$$

$$(12)$$

Selon une seconde variante, la métrique de première erreur s'exprime sous la forme :

$$M(k) = \left| LLR(k) \right| + \alpha . \sum_{i=1}^{k-1} \exp \left( -\beta \left| LLR(i) \right| \right)$$

$$(13)$$

où $\alpha > 0$ est un facteur de pondération et $\beta > 0$ un facteur d'oubli. Comme dans la première variante, le second terme de cette métrique permet de pénaliser une position en fonction du nombre de décisions peu fiables prises avant elles. Toutefois, à la différence de la première variante, elle n'introduit pas d'effet de seuil et n'écarte aucune décision antérieure. En pratique, on ne construit donc pas de liste intermédiaire, $L_S$, mais on prend en compte dans un premier temps l'ensemble des positions de la trame. La liste $L_{flip}$ est ensuite obtenue en ordonnant les indices $1, ..., N$ selon les valeurs de métrique croissantes et en ne sélectionnant que les $M_{max}$ premiers indices ainsi ordonnés.

Selon une troisième variante, la métrique de première erreur s'exprime sous la forme :

$$M(k) = \frac{1}{1 + e^{\alpha \left| LLR(k) \right|}} \prod_{i=1}^{k-1} \frac{1}{1 + e^{-\alpha \left| LLR(i) \right|}}$$

$$(14)$$

où $\alpha$ est un facteur de pondération.

Cette métrique correspond à la probabilité que la décision sur le bit à la position $k$, $\hat{u}_k$ soit la première erreur dans la trame.

En effet, la probabilité que le bit $\hat{u}_k$ soit la première erreur, est donnée par :

$$\text{Pr} \left( \hat{u}_k \; \text{1st error} \right) = p_{err}(k) \prod_{i=1}^{k-1} \left( 1 - p_{err}(i) \right)$$

$$(15)$$

où $p_{err}(k) = \text{Pr} \left( \hat{u}_k \neq u_k \middle| y_1^N, \hat{u}_1^{k-1} = u_1^{k-1} \right)$ est la probabilité que le bit $u_k$ soit incorrectement décodé, conditionnée par la séquence reçue et l'hypothèse que les bits précédents (éléments du vecteur $\hat{u}_1^{k-1}$) ont été correctement décodés.

On peut montrer que la probabilité d'erreur $p_{err}(k)$ peut être approximée par :

$$p_{err}(k) = \frac{1}{1 + e^{\alpha|LLR(k)|}} \qquad (16)$$

ce qui, compte tenu de (15), donne bien l'expression (14). On notera que dans ce cas, les indices {1, ..., $N$} devront être classés par valeurs de métrique décroissantes dans la liste $L_{flip}$.

Pour simplifier le calcul des valeurs de métrique dans l'expression (14), on pourra se contenter de n'effectuer ce calcul que pour les valeurs de LLR suffisamment faibles en valeur absolue, autrement dit pour les bits les moins fiables.

En pratique, dans une implémentation matérielle, les valeurs de LLR calculées lors du décodage sont toujours quantifiées sur un nombre prédéterminé de bits. Dans ce cas, on peut montrer, en utilisant la méthode d'évolution de densité, que la probabilité d'erreur $p_{err}(k)$ peut être approximée par :

$$p_{err}(k) = \frac{f_k\left(-|LLR(k)|\right)}{f_k\left(-LLR(k)\right) + f_k\left(LLR(k)\right)} \qquad (17)$$

où $f_k(x)$ = Pr($LLR(k) = x$) est la fonction de répartition de masse ou PMF (*Probability Mass Function*) de la variable aléatoire discrète $LLR(k)$, considérée comme quantifiée sur un nombre prédéterminé de bits. Dans ce cas, la métrique de première erreur peut s'exprimer selon (15) par :

$$M(k) = \frac{f_k\left(-|LLR(k)|\right)}{f_k\left(-LLR(k)\right) + f_k\left(LLR(k)\right)} \prod_{i=1}^{k-1} \frac{f_i\left(-|LLR(i)|\right)}{f_i\left(-LLR(i)\right) + f_i\left(LLR(i)\right)}$$

$$(18)$$

Là encore, pour simplifier le calcul des valeurs de métrique, on pourra se contenter de n'effectuer ce calcul que pour les valeurs de LLR suffisamment faibles en valeur absolue, autrement dit pour les bits les moins fiables.

Dans ce cas, la première valeur de métrique peut être obtenue de manière simplifiée par :

$$M'(k) = \begin{cases} 0 \text{ si } |LLR(k)| > S \\ \dfrac{f_k\left(-|LLR(k)|\right)}{f_k\left(-LLR(k)\right) + f_k\left(LLR(k)\right)} \prod_{i \in \Omega_k} \dfrac{f_i\left(-|LLR(i)|\right)}{f_i\left(-LLR(i)\right) + f_i\left(LLR(i)\right)} \text{ sinon} \end{cases}$$

$$(19)$$

où $\Omega_k$ est l'ensemble des indices $i < k$ tels que $|LLR(i)| \leq S$. On comprendra ainsi que seuls les bits insuffisamment fiables sont pris en compte dans le calcul de la métrique (19). Comme dans le cas de (14) et (18), on notera que les indices {1, ..., $N$} devront être classés par valeurs de métrique décroissantes dans la liste $L_{flip}$.

Les performances d'un décodeur par inversion peuvent se caractériser par deux paramètres :

- le nombre d'inversions en moyenne, lorsqu'une erreur est détectée (CRC non vérifié). Plus ce nombre est élevé et plus la latence de décodage est importante ;
- le « taux de perte d'ordre 1 » à savoir l'écart à un décodeur à inversion parfait. Ce décodeur correspond à un nombre maximal d'inversions $M_{max} = K$ et un CRC infaillible. Les performances du décodeur parfait ne dépendent alors que du canal, de la taille $N$ du code polaire, et du nombre $K + r$ où $r$ est le nombre de bits du CRC.

La Fig. 7 représente le taux de perte d'ordre 1 en fonction du nombre moyen d'inversions pour une méthode de décodage de code polaire selon le premier mode de réalisation de l'invention et la méthode de décodage SC à inversion connue de l'état de la technique.

On a considéré ici un code polaire de longueur $N = 1024$, avec un nombre de bits d'information $K = 512$, un CRC de taille 16, et un rapport signal sur bruit $SNR = 2.5dB$ sur un canal à bruit additif Gaussien.

Les performances du décodage SC à inversion de l'état de la technique ont été représentées pour trois exemples de nombre maximal d'inversions $M_{max} = \{30, 35, 40\}$.

La méthode de décodage de code polaire selon le premier mode de réalisation de l'invention a été représentée pour :

- une métrique ($M_1$) selon la première variante, telle que définie par l'expression (9), avec des exemples de valeurs de seuil $S = \{8, 10, 12, 14\}$ et pour $M_{max} = 20$ et $\alpha = 1/S$ ;
- une métrique ($M_2$) selon la seconde variante, telle que définie par l'expression (13), avec $M_{max} = 20$, $\alpha = 1.5$ et $\beta = 0.2$ ;
- une métrique ($M_3$) selon la troisième variante, telle que définie par l'expression (14), avec $M_{max} = 20$ et $\alpha = 0.3$.

On remarque que, quelle que soit la métrique envisagée, le nombre moyen d'inversions est sensiblement inférieur à celui observé dans l'état de l'art.

La métrique $M_1$ permet de viser un très faible nombre d'inversions au prix d'un taux de perte d'ordre 1 comparable ou inférieur à celui de l'état de la technique (gain en termes de latence). La métrique $M_2$, et surtout la métrique $M_3$, permettent d'atteindre un niveau de perte d'ordre 1 très faible combiné à un faible nombre d'itérations, le tout au prix d'une complexité légèrement supérieure à celle de la métrique $M_1$.

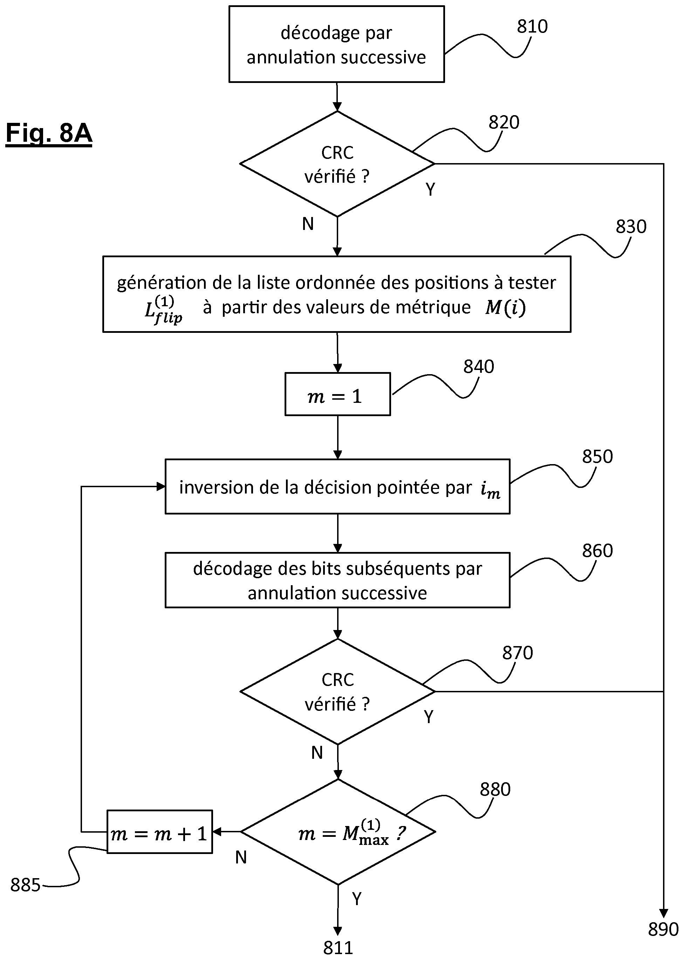

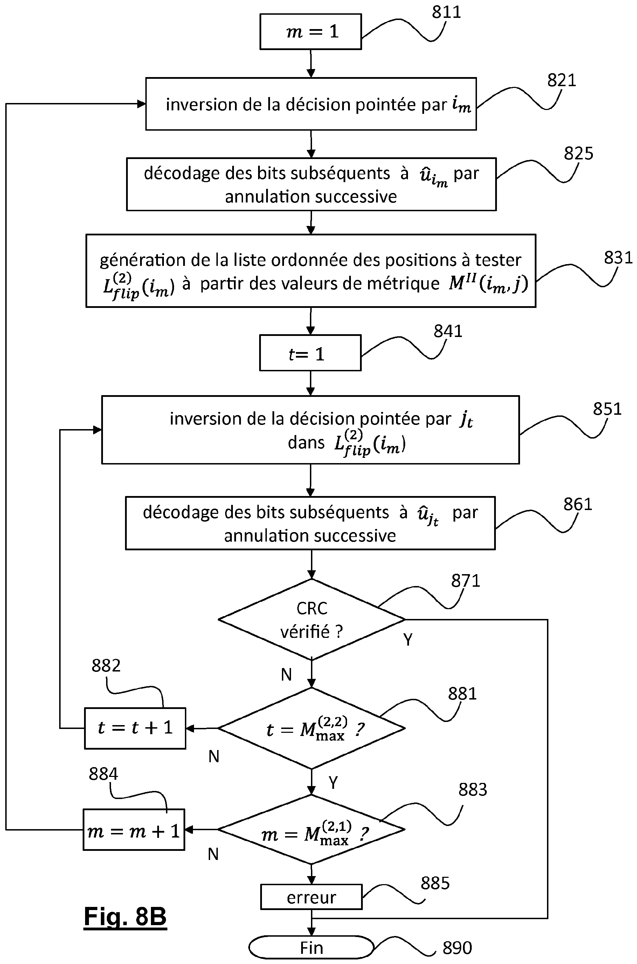

Les Fig. 8A et 8B représentent de manière schématique un ordinogramme d'une méthode de décodage de code polaire selon un second mode de réalisation de l'invention. La Fig. 8A représente une passe d'inversion d'ordre 1 et la Fig. 8B une passe d'inversion d'ordre 2.

Ce second mode de réalisation de l'invention diffère du premier au sens où, si les inversions des bits aux positions données dans la liste $L_{flip}$ ont toutes conduit à un CRC erroné, autrement dit en cas d'erreur de décodage en inversant un seul bit à la fois, on procède à une seconde passe où l'on effectue l'inversion de deux bits. L'homme du métier comprendra que, de manière générale, on pourra enchaîner $P$ passes d'inversion, la première passe n'effectuant que des inversions d'ordre 1, la seconde passe des inversions d'ordre 2, la $P^{ème}$ passe des inversions d'ordre $P$.

La première passe représentée en Fig. 8A est identique à celle de la Fig. 5. Les étapes 810 à 880 sont identiques aux étapes 510 à 580 précédemment décrites. La liste de positions à tester lors de la première passe et le nombre de ces positions sont ici notées respectivement $L_{flip}^{(1)}$ et $M_{max}^{(1)}$. On remarquera que si le CRC est vérifié à l'étape 820 ou 870, le décodage est couronné de succès dès la première passe et l'on s'arrête en 890. En revanche, si à l'issue du test 880, le décodage a échoué on effectue une seconde passe représentée en Fig. 8B.

Dans cette seconde passe, à l'étape 811, on initie à nouveau le pointeur dans la liste $L_{flip}^{(1)}$, soit $m = 1$.

On inverse alors le bit pointé par la première position, autrement dit, on inverse $\hat{u}_{i_m}$ en 821 et l'on décode par annulation successive les bits subséquents en 825. Etant donné que la première passe s'est soldée par un échec, on sait que CRC n'est pas vérifié. On génère par conséquent directement en 831 une seconde liste ordonnée $L_{flip}^{(2)}(i_m)$ des bits subséquents à $\hat{u}_{i_m}$, au moyen d'une métrique de seconde erreur $M^{II}(i_m, j)$.

La métrique de seconde erreur est similaire à la métrique de première erreur, à la différence près que l'on ne prend en compte que les décisions prises sur les bits à partir de la position $i_m + 1$, soit pour les différentes métriques de première erreur $M_1, M_2, M_3$ envisagées en (9), (13), (14) :

$$M_1^{II}(i_m, j) = \left| LLR(j) \right| + \alpha^{II}.S.Card\left\{ i \in \left[ i_m + 1, .., j-1 \right], \left| LLR(i) \right| < S \right\}$$

$$(20\text{-}1)$$

$$M_2^{II}(i_m, j) = \left| LLR(j) \right| + \alpha^{II}.\sum_{i=i_m+1}^{j-1} \exp\left( -\beta \left| LLR(i) \right| \right) \qquad (20\text{-}2)$$

$$M_3^{II}(i_m, j) = \frac{1}{1 + e^{\alpha^{II}\left| LLR(j) \right|}} \prod_{i=i_m+1}^{j-1} \frac{1}{1 + e^{-\alpha^{II}\left| LLR(i) \right|}} \qquad (20\text{-}3)$$

Où $0 < \alpha^{II} \leq 1$ est un facteur de pondération pour la seconde métrique, qui peut être égal ou non à $\alpha$.

Dans le cas pratique simplifié, où les valeurs de LLR sont quantifiées, la seconde métrique peut prendre la forme:

$$M_3^{II}(i_m, j) = \begin{cases} 0 \text{ si } |LLR(j)| > S \\ \dfrac{f_j(-|LLR(j)|)}{f_j(-LLR(j)) + f_j(LLR(j))} \displaystyle\prod_{i \in \Omega_{i_m,j}} \dfrac{f_i(-|LLR(i)|)}{f_i(-LLR(i)) + f_i(LLR(i))} \text{ sinon} \end{cases}$$

$$(20\text{-}4)$$

où $\Omega_{i_m,j}$ est l'ensemble des indices $i_m < i < j$ tels que $|LLR(i)| \leq S$ et avec les mêmes notations que précédemment.

Il convient de noter que la métrique choisie pour la seconde erreur ne sera pas nécessairement de même type que la métrique choisie pour la première erreur.

A l'étape 841, on commence le balayage des positions pour la seconde inversion en initialisant un second pointeur $t = 1$. A l'étape 851, on effectue une inversion pour le bit pointé par le second pointeur, autrement dit, on inverse le bit $\hat{u}_{j_t}$ et l'on effectue en 861 un décodage par annulation successive à partir de ce bit.

On teste en 871 si le CRC est vérifié. Dans l'affirmative, la seconde passe de décodage est couronnée de succès et l'on s'arrête en 890. Dans le cas contraire, on teste d'abord, en 881, si l'on a épuisé la liste des $M_{\max}^{(2,2)}$ secondes positions de la liste $L_{flip}^{(2)}(i_m)$. Si ce n'est pas le cas, on incrémente le second pointeur en 882, soit $t = t + 1$. En revanche, si l'on a testé tous les bits dans les positions de $L_{flip}^{(2)}(i_m)$, on vérifie en 883 si l'on a testé les $M_{\max}^{(2,1)}$ premières positions de $L_{flip}^{(1)}$, où $M_{\max}^{(2,1)} \leq M_{\max}^{(1)}$ est un nombre maximal prédéterminé de premières positions que l'on peut inverser lors de la seconde passe. Si ce n'est pas le cas, on incrémente le premier pointeur en 884 et l'on retourne à l'étape 821 pour effectuer une inversion à la position suivante de la liste $L_{flip}^{(1)}$. En revanche, si l'on a épuisé la liste $L_{flip}^{(1)}$, on déclare le décodage erroné en 885 et l'on termine en 890.

Ce second mode de réalisation est caractérisé par un nombre total d'inversions autorisées de $N_{\max}^{inv} = M_{\max}^{(1)} + M_{\max}^{(2,1)} M_{\max}^{(2,2)}$ et par conséquent par un nombre maximal de tentatives de décodage SC égal à $N_{\max}^{dec} = N_{\max}^{inv} + 1$.

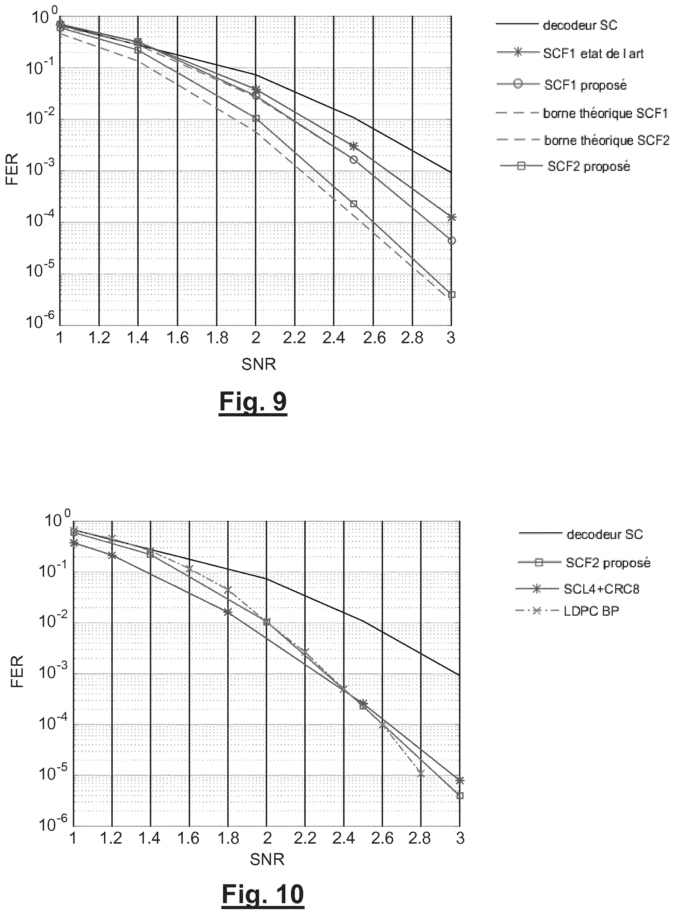

La Fig. 9 représente un taux d'erreur trame (FER) en fonction du rapport signal sur bruit (SNR) pour des méthodes de décodage selon les premier et second modes de réalisation de l'invention ainsi que pour des méthodes de décodage connues de l'état de la technique.

Le code polaire utilisé était un code de taille $N$ = 1024 avec $K$ = 512 bits d'information et 16 bits de CRC.

La courbe 910 correspond à un décodage à annulation successive (par conséquent sans CRC) connu de l'état de la technique, la courbe 920 correspond au décodage à inversion, connu également de l'état de la technique (SCF1), décrit en relation avec la Fig. 4.

La courbe 930 correspond à un décodage à inversion selon le premier mode de réalisation de l'invention (utilisant la métrique $M_3$ précitée, $M_{\max}$ = 20, $\alpha$ = 0.3) et la courbe 940 représente la limite théorique d'un décodage SCF1 ($M_{\max} = K$, CRC infaillible). On remarque que la courbe 930 est très proche de la courbe 940 et que, par conséquent, le décodage proposé atteint sensiblement les limites théoriques de ce type de décodage. On observe un gain en termes de FER. Par ailleurs, et de manière plus significative, le nombre moyen d'inversions est divisé par un facteur 2 à 3, ce qui représente une réduction sensible de latence.

A titre comparatif, on a représenté en 960 la borne théorique de FER pour un décodage à deux inversions parfait SCF2 ($M_{\max}^{(1)} = M_{\max}^{(2,1)} = M_{\max}^{(2,2)} = K$, CRC infaillible). On notera que si les performances du décodage selon le premier mode de réalisation représentent une amélioration sensible par rapport à l'état de l'art, elles restent toutefois sensiblement inférieures à la borne théorique de SCF2. Celle-ci est toutefois approchée de manière satisfaisante par la méthode de décodage selon le second mode de réalisation de l'invention (utilisant la métrique $M_3$ tant pour la première inversion que pour la seconde inversion) dont la courbe de performances est donnée en 950.

La Fig. 10 représente un taux d'erreur trame en fonction du rapport signal sur bruit pour la méthode de décodage selon le second mode de réalisation de l'invention en comparaison avec une méthode de décodage SC de liste, SCL4+CRC8 (taille de CRC égal à 8 et taille de liste égal à 4) et une méthode de décodage LDPC par propagation de croyances (belief propagation, en anglais), LDPC-BP. La courbe 1010 correspond à un décodage SC conventionnel, la courbe 1020 correspond à un décodage selon le second mode de réalisation, la courbe 1030 à un décodage selon SCL4+CRC8 et la courbe 1040 à un décodage LDPC-BP avec les mêmes paramètres $N$ et $K$ que le code polaire (le nombre d'itérations a été pris égal à 100). On notera que le second mode de réalisation permet d'obtenir des performances comparables au décodage par liste ou au décodage LDPC par propagation de croyances pour une complexité sensiblement moindre.

Comme mentionné précédemment, le mode de réalisation illustré en Figs. 8A et 8B peut être généralisé à une passe d'inversion d'ordre $P$. Plus précisément, lorsque la passe d'inversion d'ordre $P$ - 1 a échoué, c'est-à-dire lorsque toutes les configurations d'inversion d'ordre $P$ - 1 n'ont pas permis de réaliser un décodage SC conduisant à un CRC nul, on considère les configurations d'inversion d'ordre $P$.

Toutefois, le balayage des configurations d'inversion d'ordre $P$ n'est pas nécessairement optimal si l'on suit le classement des configurations d'inversion d'ordre $P$ - 1. Ainsi, par exemple, dans le cas des Figs. 8A et 8B, où $P$ = 2, si $i_m$ et $i_{m+1}$ sont deux positions successives dans la liste $L_{flip}^{(1)}$, avec $M^1(i_m) < M^1(i_{m+1})$ (première variante avec exploration selon les valeurs de métrique croissantes), la métrique de seconde erreur d'une position $j$ de $L_{flip}^{(2)}(i_m)$, soit $M_1^{II}(i_m, j)$, ne sera pas nécessairement inférieure à la métrique de seconde erreur d'une position $j'$ de $L_{flip}^{(2)}(i_{m+1})$, soit $M_1^{II}(i_{m+1}, j')$. En d'autres termes, l'ordre lexicographique dans l'ensemble $\mathcal{E}_2 = \left\{ (i, j) \mid i \in L_{flip}^{(1)}, j \in L_{flip}^{(2)}(i) \right\}$ des configurations d'inversion d'ordre 2 n'est pas optimal en termes de latence. Pour y remédier on peut classer l'ensemble $\mathcal{E}_2$ des configurations d'inversion d'ordre 2 au moyen d'une métrique $M_1^{(2)}$ (alternativement $M_2^{(2)}$, $M_3^{(2)}$) telle que définie plus loin.

De manière générale, on pourra classer l'ensemble $\mathcal{E}_P$ des configurations d'inversion d'ordre $P$ au moyen d'une métrique $M_1^{(P)}$ (alternativement au moyen d'une métrique $M_2^{(P)}$ ou $M_3^{(P)}$) obtenue par récurrence.

Plus précisément, la valeur de la métrique $M_1^{(P)}$ (resp. $M_2^{(P)}$, $M_3^{(P)}$) associée à une configuration d'inversion $\varepsilon^{(P)}$ = ($i_1$, $i_2$, ..., $i_{P-1}$, $i_P$) avec $i_1 < i_2 < ... < i_P$ se déduit de la valeur de métrique $M_1^{(P-1)}$ (resp. $M_2^{(P-1)}$, $M_3^{(P-1)}$), de la configuration d'inversion $\varepsilon^{(P-1)}$ = ($i_1$, $i_2$, ..$i_{P-1}$) et des valeurs de LLR des bits $k = i_{P-1}$, $i_{P-1}$ + 1,...,$i_P$ de la trame obtenue par décodage SC des bits subséquents à $u_{i_{P-1}}$ après que les décisions sur les bits aux positions $i_1$, $i_2$, ..$i_{P-1}$ aient été inversées (autrement dit après avoir inversé $\hat{u}_{i_1}$, $\hat{u}_{i_2}$,...,$\hat{u}_{i_{P-1}}$), notées ci-après $LLR(\varepsilon^{(P-1)}, k)$, $k = i_{P-1}$, $i_{P-1}$ + 1, ..., $i_P$. Plus précisément :

$$M_1^{(P)}(\varepsilon^{(P)}) = M_1^{(P-1)}(\varepsilon^{(P-1)}) + \left| LLR(\varepsilon^{(P)}) \right| + \alpha^{(P)} S.Card\left\{ k \in \left[ i_{P-1} + 1, ..., i_P - 1 \right], \left| LLR(\varepsilon^{(P-1)}, k) \right| < S \right\}$$

$$(21-1)$$

$$M_2^{(P)}(\varepsilon^{(P)}) = M_2^{(P-1)}(\varepsilon^{(P-1)}) + \left| LLR(\varepsilon^{(P)}) \right| + \alpha^{(P)} \sum_{k=i_{P-1}+1}^{i_P-1} \exp\left( \left| LLR(\varepsilon^{(P-1)}, k) \right| \right)$$

$$(21-2)$$

$$M_3^{(P)}(\varepsilon^{(P)}) = M_3^{(P-1)}(\varepsilon^{(P-1)}) \cdot \frac{1}{1 + \exp\left( \alpha^{(P)} \left| LLR(\varepsilon^{(P)}) \right| \right)} \cdot \prod_{k=i_{P-1}+1}^{i_P-1} \frac{1}{1 + \exp\left( -\alpha^{(P)} \left| LLR(\varepsilon^{(P)}, k) \right| \right)}$$

$$(21-3)$$

avec $LLR(\varepsilon^{(P)})$ = $LLR(\varepsilon^{(P-1)}, i_P)$ et où $0 < \alpha^{(P)} \leq 1$ est un facteur de pondération de la $P^{ème}$ métrique (les facteurs de pondération des métriques successives peuvent tous être égaux à un même coefficient $\alpha$) et où les métriques ci-dessus sont respectivement initialisées par :

$$M_1^{(0)}(\mathcal{E}^{(0)}) = 0 \qquad\qquad (22\text{-}1)$$

$$M_2^{(0)}(\mathcal{E}^{(0)}) = 0 \qquad\qquad (22\text{-}2)$$

$$M_3^{(0)}(\mathcal{E}^{(0)}) = 1 \qquad\qquad (22\text{-}3)$$

On comprendra que le balayage des configurations d'inversion sera effectué selon les valeurs croissantes de métrique $M_1^{(P)}$ et $M_2^{(P)}$ et les valeurs décroissantes de métrique $M_3^{(P)}$. On notera aussi que

$$M_1^{(P)}(\mathcal{E}^{(P-1)}, k) > M_1^{(P-1)}(\mathcal{E}^{(P-1)}), \quad M_2^{(P)}(\mathcal{E}^{(P-1)}, k) > M_2^{(P-1)}(\mathcal{E}^{(P-1)}), \quad M_3^{(P)}(\mathcal{E}^{(P-1)}, k) < M_3^{(P-1)}(\mathcal{E}^{(P-1)}),$$

ce qui assure le caractère monotone de la métrique lorsque l'on passe d'une configuration d'inversion d'ordre donné à une configuration d'inversion d'ordre supérieur. Si toutes les tentatives de décodage SC de la trame ont échoué en appliquant successivement les configurations d'inversion d'ordre $P$, dans l'ordre de leurs valeurs de métrique, on passe aux configurations d'inversion d'ordre $P + 1$, et ce jusqu'à ce que le décodage SC de la trame réussisse (CRC nul) ou que l'on atteigne une ordre maximal $P_{\max}$ prédéterminé.

## Revendications

1. Méthode de décodage d'un code polaire dans laquelle on effectue une première étape de décodage par annulation successive (510,810) et, dans le cas où l'on détecte que la trame décodée est erronée (520,820), on génère (530,830) une première liste ($L_{flip}$) ordonnée de positions dans la trame pour lesquelles une inversion de bit est à tester, et que pour chaque position de la première liste et dans l'ordre de celle-ci, on inverse (550,850) la valeur du bit de la trame correspondant à ladite position et l'on effectue un deuxième décodage par annulation successive (560,860) des bits suivants de la trame, jusqu'à ce que la trame décodée ne présente pas d'erreur ou que la première liste ait été épuisée, **caractérisée en ce que** les bits de la première liste sont ordonnés en fonction d'une première métrique ($M(k)$), la valeur de ladite première métrique pour un bit de la trame dépendant de la fiabilité de la décision sur ce bit ainsi que de la fiabilité des décisions sur au moins une partie des bits qui le précèdent dans la trame.

2. Méthode de décodage d'un code polaire selon la revendication 1, **caractérisée en ce que** la valeur de la première métrique pour le $k^{\text{ème}}$ bit de la trame est donnée par $M(k) = |LLR(k)| + \alpha.S.Card\{\Omega_k\}$ où $\Omega_k$ est l'ensemble des indices $i < k$ tels que $|LLR(i)| \leq S$, $LLR(i)$ est le rapport logarithmique de vraisemblance du $i^{\text{ème}}$ bit de la trame, $S > 0$ est une valeur de seuil et $0 < \alpha \leq 1$ est un facteur de pondération.

3. Méthode de décodage d'un code polaire selon la revendication 2, **caractérisée en ce que** le facteur de pondération $\alpha$ est choisi sensiblement égal à $1 / S$.

4. Méthode de décodage d'un code polaire selon la revendication 1, **caractérisée en ce que** la valeur de la première métrique pour le $k^{\text{ème}}$ bit de la trame est donnée par $M(k) = \left|LLR(k)\right| + \alpha.\sum_{i=1}^{k-1} \exp\left(-\beta\left|LLR(i)\right|\right)$ où $LLR(i)$ est le rapport logarithmique de vraisemblance du $i^{\text{ème}}$ bit de la trame, $0 < \alpha \leq 1$ est un facteur de pondération et $\beta$ un facteur d'oubli.

5. Méthode de décodage d'un code polaire selon la revendication 1, **caractérisée en ce que** la valeur de la première métrique pour le $k^{\text{ème}}$ bit de la trame est donnée par $M(k) = \dfrac{1}{1 + e^{\alpha|LLR(k)|}} \prod_{i=1}^{k-1} \dfrac{1}{1 + e^{-\alpha|LLR(i)|}}$ où $LLR(i)$ est le rapport logarithmique de vraisemblance du $i^{\text{ème}}$ bit de la trame, $\alpha$ est un facteur de pondération.

6. Méthode de décodage d'un code polaire selon la revendication 1, **caractérisée en ce que** la valeur de la première métrique pour le $k^{ème}$ bit de la trame est donnée par :

$$M(k) = \begin{cases} 0 \text{ si } |LLR(k)| > S \\ \dfrac{f_k\left(-|LLR(k)|\right)}{f_k\left(-LLR(k)\right) + f_k\left(LLR(k)\right)} \displaystyle\prod_{i \in \Omega_k} \dfrac{f_i\left(-|LLR(i)|\right)}{f_i\left(-LLR(i)\right) + f_i\left(LLR(i)\right)} \text{ sinon} \end{cases}$$

où $\Omega_k$ est l'ensemble des indices $i < k$ tels que $|LLR(i)| \leq S$, $LLR(i)$ est le rapport logarithmique de vraisemblance du $i^{ème}$ bit de la trame, $S > 0$ est une valeur de seuil, et $f_i$ est la fonction de répartition de masse du rapport $LLR(i)$ quantifié sur un nombre prédéterminé de bits.

7. Méthode de décodage d'un code polaire selon l'une des revendications précédentes, **caractérisée en ce que** si la première liste est épuisée et que la trame décodée est toujours erronée, pour chaque position $(i_m)$ de la première liste $(L_{flip})$, dite première position, on inverse le bit en cette première position (821), on effectue un troisième décodage par annulation successive des bits subséquents de la trame (825) et l'on génère (831) une seconde liste ordonnée de secondes positions $\left(L_{flip}^{(2)}(i_m)\right)$ dont l'inversion, combinée à l'inversion du bit $i_m$, est à tester, les bits de la seconde liste étant ordonnés en fonction d'une seconde métrique $(M^{II}(i_m, j))$, la valeur de ladite seconde métrique pour un bit de la trame dépendant de la fiabilité de la décision sur ce bit ainsi que de la fiabilité des décisions sur au moins un sous-ensemble de bits compris strictement entre les premières positions $i_m$ et les secondes positions $j$, et que, pour chaque seconde position ($j$) de la seconde liste, dans l'ordre de cette seconde liste, on inverse le bit en cette seconde position et l'on effectue un quatrième décodage par annulation successive des bits subséquents de la trame (861), les troisième décodage et quatrième décodage étant répétés jusqu'à ce que la trame décodée ne présente pas d'erreur ou que la première liste et les secondes listes respectivement associées à chacune des premières positions de la première liste aient toutes été épuisées.

8. Méthode de décodage d'un code polaire selon la revendication 7, **caractérisée en ce que** la valeur de la seconde métrique pour le $j^{ème}$ bit de la trame est donnée par $M^{II}(i_m, j) = |LLR(j)| + \alpha^{II}.S.Card\{\Omega_{i_m,j}\}$, où $\Omega_{i_m,j}$ est l'ensemble des indices $i_m < i < j$ tels que $|LLR(i)| \leq S$, $LLR(i)$ est le rapport logarithmique de vraisemblance du $i^{ème}$ bit de la trame, $S > 0$ est une valeur de seuil et $0 < \alpha^{II} \leq 1$ est un facteur de pondération.

9. Méthode de décodage d'un code polaire selon la revendication 8, **caractérisée en ce que** le facteur de pondération $\alpha^{II}$ est choisi sensiblement égal à $1/S$.

10. Méthode de décodage d'un code polaire selon la revendication 7, **caractérisée en ce que** la valeur de la seconde métrique pour le $j^{ème}$ bit de la trame est donnée par $M^{II}(i_m, j) = |LLR(j)| + \alpha^{II} . \displaystyle\sum_{i=i_m+1}^{j-1} \exp\left(-\beta |LLR(i)|\right)$ où $LLR(i)$ est le rapport logarithmique de vraisemblance du $i^{ème}$ bit de la trame, $0 < \alpha^{II} \leq 1$ est un facteur de pondération et $\beta$ un facteur d'oubli.

11. Méthode de décodage d'un code polaire selon la revendication 7, **caractérisée en ce que** la valeur de la seconde métrique pour le $j^{ème}$ bit de la trame est donnée par $M^{II}(i_m, j) = \dfrac{1}{1 + e^{\alpha^{II}|LLR(j)|}} \displaystyle\prod_{i=i_m+1}^{j-1} \dfrac{1}{1 + e^{-\alpha^{II}|LLR(i)|}}$ où $LLR(i)$ est le rapport logarithmique de vraisemblance du $i^{ème}$ bit de la trame, $\alpha^{II}$ est un facteur de pondération.

12. Méthode de décodage d'un code polaire selon la revendication 7, **caractérisée en ce que** la valeur de la seconde métrique pour le $j^{ème}$ bit de la trame est donnée par:

$$M_3^{II}(i_m, j) = \begin{cases} 0 \text{ si } |LLR(j)| > S \\ \dfrac{f_j(-|LLR(j)|)}{f_j(-LLR(j)) + f_j(LLR(j))} \displaystyle\prod_{i \in \Omega_{i_m,j}} \dfrac{f_i(-|LLR(i)|)}{f_i(-LLR(i)) + f_i(LLR(i))} \text{ sinon} \end{cases}$$

où $\Omega_{i_m,j}$ est l'ensemble des indices $i_m < i < j$ tels que $|LLR(i)| \leq S$, $LLR(i)$ est le rapport logarithmique de vraisemblance du $i^{ème}$ bit de la trame, $S > 0$ est une valeur de seuil, et $f_i$ est la fonction de répartition de masse du rapport $LLR(i)$ quantifié sur un nombre prédéterminé de bits.

**Patentansprüche**

1. Verfahren zum Dekodieren eines Polarcodes, bei dem ein erster Schritt der Dekodierung durch sukzessives Löschen erfolgt (510, 810) und, falls erkannt wird, dass der dekodierte Rahmen fehlerhaft ist (520, 820), eine erste geordnete Liste ($L_{flip}$) von Positionen in dem Rahmen erzeugt wird (530, 830), für die eine Bitinversion getestet werden soll, und für jede Position der ersten Liste und in deren Reihenfolge der Wert des der Position entsprechenden Bits des Rahmens invertiert wird (550, 850) und eine zweite Dekodierung durch sukzessives Löschen der nachfolgenden Bits des Rahmens erfolgt (560, 860), bis der dekodierte Rahmen fehlerfrei ist oder die erste Liste erschöpft ist, **dadurch gekennzeichnet, dass** die Bits der ersten Liste nach einer ersten Metrik (M (k)) geordnet werden, wobei der Wert der ersten Metrik für ein Bit des Rahmens von der Zuverlässigkeit der Entscheidung über dieses Bit sowie von der Zuverlässigkeit der Entscheidungen über zumindest einen Teil der diesem Bit im Rahmen vorausgehenden Bits abhängt.

2. Verfahren zum Dekodieren eines Polarcodes nach Anspruch 1, **dadurch gekennzeichnet, dass** der Wert der ersten Metrik für das *k-te* Bit des Rahmens gegeben ist durch $M(k) = |LLR(k)| + \alpha.S.Card\{\Omega_k\}$, worin $\Omega_k$ die Gesamtheit von Indizes $i < k$ ist, so dass $|LLR(i)| \leq S$ ist, wobei $LLR(i)$ das logarithmische Wahrscheinlichkeitsverhältnis des *i-ten* Bits des Rahmens ist, wobei $S > 0$ ein Schwellenwert ist und $0 < \alpha \leq 1$ ein Gewichtungsfaktor ist.

3. Verfahren zum Dekodieren eines Polarcodes nach Anspruch 2, **dadurch gekennzeichnet, dass** der Gewichtungsfaktor $\alpha$ im Wesentlichen gleich $1 / S$ gewählt wird.

4. Verfahren zum Dekodieren eines Polarcodes nach Anspruch 1, **dadurch gekennzeichnet, dass** der Wert der ersten Metrik für das *k-te* Bit des Rahmens gegeben ist durch

$$M(k) = |LLR(k)| + \alpha.\sum_{i=1}^{k-1} \exp(-\beta|LLR(i)|)$$

worin $LLR(i)$ das logarithmische Wahrscheinlichkeitsverhältnis des i-ten Bits des Rahmens ist, $0 < \alpha \leq 1$ ein Gewichtungsfaktor und $\beta$ ein Vergessensfaktor ist.

5. Verfahren zum Dekodieren eines Polarcodes nach Anspruch 1, **dadurch gekennzeichnet, dass** der Wert der ersten Metrik für das *k-te* Bit des Rahmens gegeben ist durch

$$M(k) = \frac{1}{1 + e^{\alpha|LLR(k)|}} \prod_{i=1}^{k-1} \frac{1}{1 + e^{-\alpha|LLR(i)|}}$$

worin $LLR(i)$ das logarithmische Wahrscheinlichkeitsverhältnis des i-ten Bits des Rahmens ist, wobei $\alpha$ ein Gewichtungsfaktor ist.

6. Verfahren zum Dekodieren eines Polarcodes nach Anspruch 1, **dadurch gekennzeichnet, dass** der Wert der ersten Metrik für das *k-te* Bit des Rahmens gegeben ist durch

$$M(k) = \begin{cases} 0 \text{ si } \big|LLR(k)\big| > S \\ \dfrac{f_k\left(-\big|LLR(k)\big|\right)}{f_k\left(-LLR(k)\right) + f_k\left(LLR(k)\right)} \displaystyle\prod_{i \in \Omega_k} \dfrac{f_i\left(-\big|LLR(i)\big|\right)}{f_i\left(-LLR(i)\right) + f_i\left(LLR(i)\right)} \end{cases} ;$$

worin $\Omega_k$ die Gesamtheit von Indizes $i < k$ ist, so dass $/LLR(i)/ \leq S$ ist, wobei $LLR(i)$ das logarithmische Wahrscheinlichkeitsverhältnis des $i$-ten Bits des Rahmens ist, wobei $S > 0$ ein Schwellenwert ist und $f_i$ die Massenverteilungsfunktion des quantisierten Verhältnisses $LLR(i)$ über eine vorbestimmte Anzahl von Bits ist.

7. Verfahren zum Dekodieren eines Polarcodes nach einem der vorangehenden Ansprüche, **dadurch gekennzeichnet, dass** dann, wenn die erste Liste erschöpft ist und der decodierte Rahmen immer noch fehlerhaft ist, für jede Position ($i_m$) der ersten Liste ($L_{flip}$), erste Position genannt, das Bit an dieser ersten Position invertiert wird (821), eine dritte Dekodierung durch sukzessives Löschen der nachfolgenden Bits des Rahmens erfolgt (825) und eine zweite geordnete Liste von zweiten Positionen ($L^{(2)}_{flip}(i_m)$) erzeugt wird (831), deren Inversion, kombiniert mit der Inversion des Bit $i_m$, getestet werden soll, wobei die Bits der zweiten Liste nach einer zweiten Metrik ($M^{II}(i_m, j)$) geordnet werden, wobei der Wert der zweiten Metrik für ein Bit des Rahmens von der Zuverlässigkeit der Entscheidung über dieses Bit sowie von der Zuverlässigkeit der Entscheidungen über zumindest eine Teilmenge von Bits, die strikt zwischen den ersten Positionen $i_m$ und den zweiten Positionen $j$ enthalten sind, abhängt, und dass für jede zweite Position ($j$) der zweiten Liste und in der Reihenfolge dieser zweiten Liste das Bit an dieser zweiten Position invertiert wird und eine vierte Dekodierung durch sukzessives Löschen der nachfolgenden Bits des Rahmens erfolgt (861), wobei die dritte und die vierte Dekodierung solange wiederholt werden, bis der dekodierte Rahmen fehlerfrei ist, oder dass die erste Liste und die zweiten Listen, die jeweils den ersten Positionen der ersten Liste zugeordnet sind, alle erschöpft sind.

8. Verfahren zum Dekodieren eines Polarcodes nach Anspruch 7, **dadurch gekennzeichnet, dass** der Wert der zweiten Metrik für das $j$-te Bit des Rahmens gegeben ist durch $M^{II}(im, j) = /LLR(j)/ + \alpha^{II}.S.Card\{\Omega_{im}, j\}$, worin $\Omega_{im, j}$ die Gesamtheit von Indizes $i_m < i < j$ ist, so dass $/LLR(i)/ \leq S$ ist, wobei $LLR(i)$ das logarithmische Wahrscheinlichkeitsverhältnis des $i$-ten Bits des Rahmens ist, wobei $S > 0$ ein Schwellenwert ist und $0 < \alpha^{II} \leq 1$ ein Gewichtungsfaktor ist.

9. Verfahren zum Dekodieren eines Polarcodes nach Anspruch 8, **dadurch gekennzeichnet, dass** der Gewichtungsfaktor $\alpha^{II}$ im Wesentlichen gleich $1 / S$ gewählt wird.

10. Verfahren zum Dekodieren eines Polarcodes nach Anspruch 7, **dadurch gekennzeichnet, dass** der Wert der zweiten Metrik für das $j$-te Bit des Rahmens gegeben ist durch

$$M^{II}(i_m, j) = \big|LLR(j)\big| + \alpha^{II} . \sum_{i=i_m+1}^{j-1} \exp\left(-\beta\big|LLR(i)\big|\right)$$

worin $LLR(i)$ das logarithmische Wahrscheinlichkeitsverhältnis des $i$-ten Bits des Rahmens ist, $0 < \alpha^{II} \leq 1$ ein Gewichtungsfaktor und $\beta$ ein Vergessensfaktor ist.

11. Verfahren zum Dekodieren eines Polarcodes nach Anspruch 7, **dadurch gekennzeichnet, dass** der Wert der zweiten Metrik für das das $j$-te Bit des Rahmens gegeben ist durch

$$M^{II}(i_m, j) = \frac{1}{1 + e^{\alpha^{II}\big|LLR(j)\big|}} \prod_{i=i_m+1}^{j-1} \frac{1}{1 + e^{-\alpha^{II}\big|LLR(i)\big|}}$$

worin $LLR(i)$ das logarithmische Wahrscheinlichkeitsverhältnis des $i$-ten Bits des Rahmens ist und $\alpha^{II}$ ein Gewichtungsfaktor ist.

12. Verfahren zum Dekodieren eines Polarcodes nach Anspruch 7, **dadurch gekennzeichnet, dass** der Wert der zweiten Metrik für das das *j-te* Bit des Rahmens gegeben ist durch

$$M_3^{II}(i_m, j) = \begin{cases} 0 \text{ si } |LLR(j)| > S \\ \dfrac{f_j\left(-|LLR(j)|\right)}{f_j\left(-LLR(j)\right)+f_j\left(LLR(j)\right)} \displaystyle\prod_{i\in\Omega_{i_m,j}} \dfrac{f_i\left(-|LLR(i)|\right)}{f_i\left(-LLR(i)\right)+f_i\left(LLR(i)\right)} \end{cases}$$

worin $\Omega_{im,j}$ die Gesamtheit von Indizes $i_m < i < j$ ist, so dass $/LLR(i)/ \leq S$ ist, wobei *LLR(i)* das logarithmische Wahrscheinlichkeitsverhältnis des *i-ten* Bits des Rahmens ist, wobei *S > 0* ein Schwellenwert ist und $f_i$ die Massenverteilungsfunktion des quantisierten Verhältnisses *LLR(i)* über eine vorbestimmte Anzahl von Bits ist.

**Claims**

1. Method for decoding a polar code in which a first successive cancellation decoding step (510, 810) is done, and in which if it is detected that the decoded frame is incorrect (520, 820), there is generated (530,830) a first ordered list ($L_{flip}$) of positions in the frame for which a bit inversion is to be tested, and, for each position in the first list and in the order of the first list, the value of the bit in the frame corresponding to said position is inverted (550, 850), and a second successive cancellation decoding (560,860) is carried out for subsequent bits in the frame until there is no error in the decoded frame or the first list is exhausted, **characterised in that** the bits in the first list are ordered as a function of a first metric (*M(k)*), the value of said first metric for a bit in the frame dependent on the reliability of this bit and the reliability of decisions on at least some bits preceding it in the frame.

2. Method for decoding a polar code according to claim 1, **characterised in that** the value of the first metric for the $k^{th}$ bit in the frame is given by $M(k) = |LLR(k)| + \alpha.S.Card\{\Omega_k\}$ in which $\Omega_k$ is the set of indices $i < k$ such that $|LLR(i)| \leq S$, *LLR(i)* is the logarithmic likelihood ratio for the $i^{th}$ bit in the frame, *S > 0* is a threshold value and $0 < \alpha \leq 1$ is a weighting factor.

3. Method for decoding a polar code according to claim 2, **characterised in that** the weighting factor $\alpha$ is chosen to be approximately equal to 1/*S*.

4. Method for decoding a polar code according to claim 1, **characterised in that** the value of the first metric for the $k^{th}$ bit in the frame is given by $M(k) = |LLR(k)| + \alpha.\displaystyle\sum_{i=1}^{k-1} \exp\left(-\beta|LLR(i)|\right)$ in which *LLR(i)* is the logarithmic likelihood ratio for the $i^{th}$ bit in the frame, $0 < \alpha \leq 1$ is a weighting factor and $\beta$ is a forgetting factor.

5. Method for decoding a polar code according to claim 1, **characterised in that** the value of the first metric for the $k^{th}$ bit in the frame is given by $M(k) = \dfrac{1}{1+e^{\alpha|LLR(k)|}} \displaystyle\prod_{i=1}^{k-1} \dfrac{1}{1+e^{-\alpha|LLR(i)|}}$ in which *LLR(i)* is the logarithmic likelihood ratio for the $i^{th}$ bit in the frame, $\alpha$ is a weighting factor.

6. Method for decoding a polar code according to claim 1, **characterised in that** the value of the first metric for the $k^{th}$ bit in the frame is given by:

$$M(k) = \begin{cases} 0 \text{ if } |LLR(k)| > S \\ \dfrac{f_k\left(-|LLR(k)|\right)}{f_k\left(-LLR(k)\right)+f_k\left(LLR(k)\right)} \displaystyle\prod_{i\in\Omega_k} \dfrac{f_i\left(-|LLR(i)|\right)}{f_i\left(-LLR(i)\right)+f_i\left(LLR(i)\right)} \text{ otherwise} \end{cases}$$

in which $\Omega_k$ is the set of indices $i < k$ such that $|LLR(i)| \leq S$, *LLR(i)* is the logarithmic likelihood ratio for the $i^{th}$ bit of the frame, $S > 0$ is a threshold value and $f_i$ is the mass distribution function of the $LLR(i)$ ratio quantified on a predetermined number of bits.

7. Method for decoding a polar code according to one of the preceding claims, **characterised in that** if all elements of the first list have been considered and the decoded frame is still incorrect, for each position ($i_m$) in the first list ($L_{flip}$), called first position the bit in this first position (821) is inverted, a third successive cancellation of subsequent bits in the frame (825) is performed and a second ordered list of second positions ( $L_{flip}^{(2)}(i_m)$ ) is generated (831), for which the inversion, combined with inversion of the bit $i_m$, is to be tested, the bits of the second list being ordered as a function of a second metric ($M^{II}(i_m, j)$), the value of the second metric for a bit in the frame dependent on the reliability of the decision on this bit and on the reliability of decisions on at least one subset of bits contained between the first positions $i_m$ and the second positions $j$, and that for each second position (j) in the second list, in the order of this second list, the bit at this second position is inverted and a fourth successive cancellation decoding is made on subsequent bits in the frame (861), the third decoding and the fourth decoding being repeated until the decoded frame no longer contains any errors or until the first list and the second lists associated with each of the first positions of the first list respectively have all been considered.

8. Method for decoding a polar code according to claim 7, **characterised in that** the value of the second metric for the $j^{th}$ bit in the frame is given by $M^{II}(i_m, j) = |LLR(j)| + \alpha^{II}.S.Card\{\Omega_{i_m,j}\}$ in which $\Omega_{i_m,j}$ is the set of indices $i_m < i < j$ such that $|LLR(i)| \le S$, $LLR(i)$ is the logarithmic likelihood ratio for the $i^{th}$ bit in the frame, $S > 0$ is a threshold value and $0 < \alpha^{II} \le 1$ is a weighting factor.

9. Method for decoding a polar code according to claim 8, **characterised in that** the weighting factor $\alpha^{II}$ is chosen to be approximately equal to $1/S$.

10. Method for decoding a polar code according to claim 7, **characterised in that** the value of the second metric for the $j^{th}$ bit in the frame is given by $M^{II}(i_m, j) = |LLR(j)| + \alpha^{II}. \sum_{i=i_m+1}^{j-1} \exp\left(-\beta|LLR(i)|\right)$ in which $LLR(i)$ is the logarithmic likelihood ratio for the $i^{th}$ bit in the frame, $0 < \alpha^{II} \le 1$ is a weighting factor and $\beta$ is a forgetting factor.

11. Method for decoding a polar code according to claim 7, **characterised in that** the value of the second metric for the $j^{th}$ bit in the frame is given by $M^{II}(i_m, j) = \dfrac{1}{1 + e^{\alpha^{II}|LLR(j)|}} \prod_{i=i_m+1}^{j-1} \dfrac{1}{1 + e^{-\alpha^{II}|LLR(i)|}}$ in which $LLR(i)$ is the logarithmic likelihood ratio for the $i^{th}$ bit in the frame, $\alpha^{II}$ is a weighting factor.

12. Method for decoding a polar code according to claim 7, **characterised in that** the value of the second metric for the $j^{th}$ bit in the frame is given by:

$$M_3^{II}(i_m, j) = \begin{cases} 0 \text{ if } |LLR(j)| > S \\ \dfrac{f_j\left(-|LLR(j)|\right)}{f_j\left(-LLR(j)\right) + f_j\left(LLR(j)\right)} \prod_{i \in \Omega_{i_m,j}} \dfrac{f_i\left(-|LLR(i)|\right)}{f_i\left(-LLR(i)\right) + f_i\left(LLR(i)\right)} \text{ otherwise} \end{cases}$$

in which $\Omega_{i_m,j}$ is the set of indices $i_m < i < j$ such that $|LLR(i)| \le S$, $LLR(i)$ is the logarithmic likelihood ratio for the $i^{th}$ bit of the frame, $S > 0$ is a threshold value and $f_i$ is the mass distribution function of the $LLR(i)$ ratio quantified on a predetermined number of bits.

**Fig. 1A**

**Fig. 1B**

**Fig. 2**

**Fig. 3**

**Fig. 4**

décodage par annulation successive — 410

CRC vérifié ? — 420

Y

N

génération de la liste ordonnée des positions à tester $L_{flip}$ à partir des valeurs $|LLR(i)|$ — 430

$m = 1$ — 440

inversion de la décision pointée par $i_m$ — 450

décodage des bits subséquents par annulation successive — 460

CRC vérifié ? — 470

Y

N

$m = M_{max}$? — 480

N

$m = m + 1$ — 485

Y

erreur — 487

Fin

**Fig. 5**

décodage par
annulation successive — 510

CRC
vérifié ? — 520

Y

N

génération de la liste ordonnée des positions à tester
$L_{flip}$ à partir des valeurs de métrique $M(i)$ — 530

$m = 1$ — 540

inversion de la décision pointée par $i_m$ — 550

décodage des bits subséquents par
annulation successive — 560

CRC
vérifié ? — 570

Y

N

$m = M_{\max}$? — 580

N

$m = m + 1$ — 585

Y

erreur — 587

590

Fin

Average number of flip
(N,K+CRC=(1024,512+16), SNR=2.5dB

**Fig. 6**

**Fig. 7**

**Fig. 8A**

décodage par annulation successive — 810

CRC vérifié ? — 820

génération de la liste ordonnée des positions à tester $L_{flip}^{(1)}$ à partir des valeurs de métrique $M(i)$ — 830

$m = 1$ — 840

inversion de la décision pointée par $i_m$ — 850

décodage des bits subséquents par annulation successive — 860

CRC vérifié ? — 870

$m = M_{max}^{(1)}$ ? — 880

$m = m + 1$ — 885

811

890

$m = 1$ — 811

inversion de la décision pointée par $i_m$ — 821

décodage des bits subséquents à $\hat{u}_{i_m}$ par annulation successive — 825

génération de la liste ordonnée des positions à tester $L_{flip}^{(2)}(i_m)$ à partir des valeurs de métrique $M^{II}(i_m, j)$ — 831

$t = 1$ — 841

inversion de la décision pointée par $j_t$ dans $L_{flip}^{(2)}(i_m)$ — 851

décodage des bits subséquents à $\hat{u}_{j_t}$ par annulation successive — 861

CRC vérifié ? — 871

Y

N

$t = t + 1$ — 882

$t = M_{max}^{(2,2)}$ ? — 881

N

Y

$m = m + 1$ — 884

$m = M_{max}^{(2,1)}$ ? — 883

N

Y

erreur — 885

Fin — 890

**Fig. 8B**

**Fig. 9**

**Fig. 10**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **E. ARIKAN.** Channel polarization : a method for constructing capacity-achieving codes for symmetric binary-input memoryless channels. *IEEE Trans on Infomation Theory,* vol. 55 (7), 3051-3073
- **I. TAL et al.** List decoding of polar codes. *Information Theory Proc. (ISIT),* Juillet 2011, 1-5
- **O. AFISIADIS et al.** A low-complexity improved successive cancellation decoder for polar codes. *Signais, Systems and Computers, 2014, 48th Asilomar Conference,* 2116-2120
- **Z. ZHANG et al.** A Split-Reduced Successive Cancellation List Decoder for Polar Codes. *IEEE Journal on Selected Areas in Communications,* Février 2016, vol. 34 (2), 292-303